# EUROPEAN PATENT APPLICATION

(11) **EP 2 133 622 A1**
(43) Date of publication of application: **16.12.2009**
(21) Application number: 08158122.5
(22) Date of filing: 12.06.2008
(51) Int. Cl.: F21S 8/08, F21V 19/00, H05K 1/18, F21Y 101/02

(54) **Street lighting apparatus with multiple LED-light sources**

(71) Applicant: Schreder, 1190 Bruxelles (BE)
(72) Inventor: Frankinet, Marc, 4460 Horion-Hozemont (BE); Lang, Vincent, 4400 Flemalle (BE)
(74) Representative: Leherte, Georges M.L.M.

(57) **Abstract**

The invention concerns a street lighting apparatus with multiple LED-light sources comprising a three dimensional (3D) support structure and at least one 3D orientated PCB structure for a plurality of LED sources, in which the 3D support structure is selected from :
- a cut and/or folded metal sheet structure,
- a cast, machined or molded metal or synthetic material structure,
- a stamped metal or synthetic material structure,

and the 3D orientated PCB structure is selected from:
- a flexible or semi flexible PCB structure for a plurality of LED-light sources, having a shape and/or a three dimensional orientation corresponding to said 3D support structure,
- a plurality of modular PCB structure for a plurality of LED-light sources, each comprising a plurality of LED sources, individually provided to said support structure,

whereas at least one of the 3D support structure and the PCB structure has heat sink properties.

## Description

The invention relates to the area of lighting.
More particularly the invention relates to the emerging application of Light Emitting Diodes (LED's) for lighting purposes in general, and more specifically for street lighting purposes.
LED's are considered by many to represent the future for lighting.
An early patent document in this area is for instance EP 0 890 059.

These new light sources involve new constraints and new problems in respect of development and production of lighting devices.

By applying software assisted analysis to various combinations of LED-light sources of different types with individual (secondary) optical means (such as lenses, etc.) of different types (using the photometric properties of the light sources and of the optical means as "variables"), it becomes possible to optimise the light distribution according to a desired pattern (or theoretical "lighting matrix") for a given application.
The "dimming" capability of LED-light sources provides a further useful variable in this context.
Software assisted calculations make possible to calculate the theoretical result that can be achieved by combining LED-light sources of different types with optical means of different types (again, using the photometric properties of the light sources and the optical means as "variables"), so that the performance of lighting devices can be predicted.

In that context one can represent the light distribution of a single LED by a polar diagram. Each LED has its own specific light distribution.

In addition to the naked LED-light source one can use secondary optics, such as a lens, a reflector, etc, which modify the light distribution.
By combining different types of LED-light sources with different types of secondary optics, one arrives at numerous light distributions defining typical beams (including very intensive, semi narrow, asymmetrical beams).
Each such basic light distribution, representative of a specific LED-light source combined with a specific secondary optics, can be referred to as a "Light Distribution Unit" (LDU).
Several LDU's together provide a global light distribution which can be suitable in a lighting device, such as a (street) lighting device or "luminaire, comprising multiple LED-light sources.
The luminaire can be seen as composed of facets emitting light in some direction.
Based on the different LDU's one can thus build a desired light distribution, by adding up different LDU's.
Applying these calculation methods and representation concepts for the relevant variables, one can calculate which LDU's to use for creating a desired global light distribution (as a specific pattern or "lighting matrix").

For optimising the performance of a (street) lighting device involving multiple LED-light sources within a common frame, one can thus select
- specific LED-light sources from a plurality of types of LED-light sources,
- specific secondary optics from a plurality of types of secondary optics, for each selected LED light source, and
- specific orientations for each of those LED-light sources and/or secondary optics,
whereas variables representing the light distribution in function of direction coordinates can be associated to each LED light source and its secondary optics, and simulations of cumulative variables for multiple combinations of selected LED-light sources, selected secondary optics and selected orientations, can be compared, using software assisted calculations, with selected global light distributions, so as to designate combinations of selected LED-light sources, selected secondary optics and selected orientations showing an optimal fit with said selected global light distributions.

In such performance optimisation methods the variables associated to each LED light source and its secondary optics are preferably defined in accordance with so called "a C-γ system of coordinates", "Intensity tables", "Polar diagrams of luminous intensity", "Cartesian diagrams of luminous intensity", "Utilisation factor curves", and/or "Isolux diagrams",
as, per se, well known in the art .
Reference is made in this respect to the theory of intensity tables of lighting devices ("luminaries"), and the standard system of coordinates, named C-gamma, as well as the standards of the "Commission Internationale de l'Eclairage" (CIE) which has standardized the presentation format of the intensity tables for road lighting devices.

The concepts referred to above concern the more theoretical aspects of lighting design and lighting construction.
These concepts are the subject matter of European patent application 07100432.9 (not yet published on the filing date of the present patent application).
Beside these more theoretical aspects there exist of course also practical construction and manufacturing aspects and problems to the design and construction of LED lighting apparatuses.
One such practical construction and manufacturing aspect / problem is more particularly the adequate three dimensional (3D) positioning of the LED light sources (in the context of the theoretical concepts referred to above), and cost efficient ways of achieving such positioning.

Various proposals have been made in this area.
Thus, the US patent publication 2003/0090910 discloses a LED lighting device comprising multiple LED members, a plane circuit board, a fixing cover, a circuit board mounting seat, drive circuitry and a base, to provide a lamp compatible with standard filament bulb seats.
US 2005/0254264 discloses a LED lighting device comprising a metal core having a bulbous body and a foot, a circuit board (formed of flexible printed circuit board) material substantially surrounding the metal core, and LED light sources, to provide a light source compatible with existing filament lamp sockets.
WO 2005/090852 discloses a lighting element using LED-sources, surface mounted on a flexible substrate that can be bent and conform to a preestablished structure, and a center post extending electrical conductors to the circuit board.
GB 2 360 461 discloses light sources (in particular for medical photodynamic therapy applications) comprising an array of LED sources mounted on a flexible backing, wherein the LED sources may be independently switchable.

It is the object of the present invention to provide a solution for the adequate 3D positioning of LED light sources in LED lighting apparatuses, more particularly in street lighting apparatuses.

The essence of the invention resides in the concept of providing a three dimensional (3D) support structure with at least one Printed Circuit Board (PCB) structure for a plurality of LED sources having a three dimensionally orientation corresponding to said 3D support structure, or with a plurality of modular PCB structures, each comprising a plurality of LED sources, individually provided to said support structure, whereas the combination of the support structure and the PCB structure has proper "heat sink" properties.

The expression "heat sink" properties as used in the present context refers to the capability of the lighting installation to properly dissipate the heat generated by the LED-light sources, during operation, be it via the support structure and/or via the PCB structure.
Heat sink properties thus correspond / are linked to the thermal conduction properties of the combination of the support structure and the PCB structure.

The expression "LED source" / "LED light source" as referred to in the present context covers / comprises any combination of
- specific LED-light sources, as selected from a plurality of types of LED-light sources,
- specific secondary optics, as selected from a plurality of types of secondary optics, for each selected LED light source, and
- specific orientations for each of those LED-light sources and/or secondary optics,
in the sense of a "Light distribution Unit" (LDU) within the meaning of the light distribution concept referred to above.

Against the above background, the invention provides a new type of street lighting apparatuses with multiple LED-light sources comprising a three dimensional (3D) support structure and at least one 3D orientated PCB structure for a plurality of LED sources, said 3D support structure being selected from :
- a cut and/or folded (bended) metal sheet structure,
- a cast, machined and/or molded metal or synthetic material structure, and
- a stamped metal or synthetic material structure,
and said 3D orientated PCB structure being selected from :
- a flexible or semi flexible PCB structure for a plurality of LED-light sources, having a shape and/or a three dimensional orientation corresponding to said 3D support structure, and
- a plurality of modular PCB structures, each comprising a plurality of LED light sources, individually provided to said support structure,
whereas at least one of the 3D support structure and the PCB structure has heat sink properties.

In a first preferred embodiment of the invention said flexible / semi flexible PCB structure (flexible / semi-flexible print boards) more particularly comprises a tree or fishbone / herringbone shaped PCB structure, with a main stem and side branches for supporting one LED or a set of LED's, provided on a three dimensional support structure of cut and folded metal, of cast, machined or molded metal or synthetic material, or of stamped metal or synthetic material.

Lighting devices (street lighting devices) according to the invention, comprising multiple LED-sources within a common frame, can be obtained by providing the 3D base structure, providing one or more flexible or semi-flexible printed circuits adapted to receive the LED-light sources, and applying the (semi) flexible printed circuit on the 3D base structure so as to provide a defined three dimensional configuration of the LED-light sources' positions and orientations.
All the LED-light sources, with any secondary optics and electronic components are mounted on a (flat) flexible semi flexible print board to be placed on and adapted to any kind of 3D support structure / base structure, fixing the orientation of the LED-light sources.
The support structure can, for instance, involve a bended metal sheet, a deep drawn metal structure, a die cast metal structure, or a machined aluminium structure.

The (semi) flexible printed circuits may suitably involve several modules for one or more LED-light sources, with the capability to have each light source within one module directed into a selected direction and/or provided with individual optical means, and with each module having the capability to be bended according to a selected direction.

Flexible / semi flexible print boards according to the invention may involve a flexible, semi flexible or non flexible (rigid) stem of its tree or fishbone /herringbone shaped structure, but what is most essential is that the side branches of the tree or fishbone / herringbone shaped structure, for supporting the LED(s), are connected in a bendable / flexible way to the stem so that the LED's / LED sets supported on such side branches can, properly be oriented in function of the shape of the supporting structure.
This can be achieved bay providing the complete tree or fishbone /herringbone shaped structure as a flexible PCB structure, or only the side braches as flexible PCB structures, or only the side branch part, connecting the support part for the LED / LED set to the stem, as a flexible part.

In another preferred embodiment of the invention the 3D support structure more particularly forms a 3D heat sink support structure, and a plurality of modular PCB structures, each comprising a plurality of LED sources, individually provided to said support structure, constitute a structure having photometric oriented facets.

According to still another preferred embodiment of the invention, a plurality of individual modular PCB structures are provided on thermally conductive support structures, applied to the external surface of a lighting apparatus.
Most preferably the thermally conductive support structures consist of cut and/or folded metal sheet structures.

According to the latter two embodiments the individual modular PCB structures, each comprising a plurality of LED sources, may, of course, each separately be rigid in structure.

According to a further preferred feature of the latter two embodiments of the invention, the (street) lighting apparatus comprises
individual modules, composed of a heat sink structure (to dissipate, on its backside, the heat generated by the LED-light sources), printed circuitry board (rigid, or flexible for allowing multiple LED orientations on one module), LED-light sources with necessary electronic components, and optional protection and/or tightness features,
a support structure, composed of a 3D main structure, providing an appropriate orientation for each module,
a protector structure (global protector or individual protector for each module),
optionally with a suitably designed "chimney" zone behind the 3D main structure to evacuate the heat into the ambient air.

Such (street) lighting devices can be obtained by providing
modules, composed of a heat sink structure, a print board, LED-light sources, necessary electronic components, and optional protection and/or tightness features,
on a support structure, composed of a 3D main structure, providing an appropriate orientation for each module, and
applying a protector structure (global protector or individual protector for each module).

Within the essential, general concept of the invention referred to above (3D support structure with 3D orientated PCB structure(s) for a plurality of LED light sources, having "heat sink" properties) various additional features are possible to achieve special effects, such as
- essentially radially oriented directional LED lighting (radially oriented around a central axis), applying the concept of 3D support structures with 3D orientated PCB structures as LED connectors, combined with essentially axially oriented LED lighting (parallel to said central axis) and a tubular diffuser for ambience lighting.
- varying the lighting distribution of a LED lighting structure applying the concept of 3D support structures with 3D orientated PCB structures as LED connectors, by using adjustable refractor screens, adapted to be moved around a vertical rotation axis or a horizontal rotation axis.

For controlling a lighting device according to the invention, in particular a street lighting device, involving multiple LED-light sources within a common frame, using several modules of one or more LED-light sources, each light source within one module being directed into a selected direction and/or provided with individual optical means, and each module being directed into a selected direction, the power feed to each module, optionally each light source, may very suitably be controlled separately.
A software assisted method may be used for controlling the performance of (street) lighting devices according to the invention, where the power feed to each module, optionally each light source, is separately regulated by software controlled means.
The apparatuses according to the invention and their control process /software assisted control method may involve one or more of the following further features :
- the light sources in one module are directed into selected cooperating directions,
- the power feed to each module, optionally each light source, is separately controlled in respect of amperage ("dimmability") and / or frequency.

An important feature of the lighting concept disclosed above resides in the fact that the multiple light sources can be easily dimmed (reducing of light intensity) or switched on and off, by using appropriate electronic drivers (as such well known in the art).
This provides for optimal adaptation of the light distribution to various parameters, based on the facets concept and by controlling the light intensity of some LED-light sources in some directions, with even the possibility to modify the colour of the emitted light by using different types of coloured LED-light sources or RGB LED sources.
Such modification of the light distribution and / or colour distribution can thus adapt the photometrical performance of a lighting device according to many parameters, such as
climate, for instance due to rain, snow, frost, fog, ...
time, for instance due to ageing of the road surface leading to changed reflection characteristics, clogging of the road surface, renovation of the road surface, modification of light level with time (day, evening, night, ...), seasons ("warm white" during winter, "cool white" during summer)
traffic, for instance due to density of traffic, presence of accident or parked vehicle, traffic speed, type of vehicles (cars, trucks, ...)
geometry, for instance due to the configuration of the road (width, curvature, ...), spacing between lighting poles, specificities and singularities (round about, crossing, zebra crossing, ...)
geography, for instance according to different countries, specifications, norms (light level, colour, ...) - adaptation to different local requirements

Further features and / or details of the invention will be explained while making reference to specific embodiments of the invention as shown on the attached drawings, in which
Figure 1 schematically represents (how obtaining) a semi flexible tree shaped PCB structure according to the invention
Figures 2 - 4 represent, respectively,
   a cut and bended metal sheet embodiment,
   a cast aluminum / molded synthetic material embodiment, and
   a stamped metal or synthetic material embodiment,
   of a 3D support structure according to the invention, for a PCB structure according to figure 1;
Figures 5 and 6 represent a cast or stamped 3D "heat sink" support structure according to the invention, shown respectively without and with modular PCB structures with LED's, according to the invention;
Figure 7 represents an embodiment of the invention with modular PCB structures provided on thermally conductive support structures, applied to the external surface of a lighting apparatus.

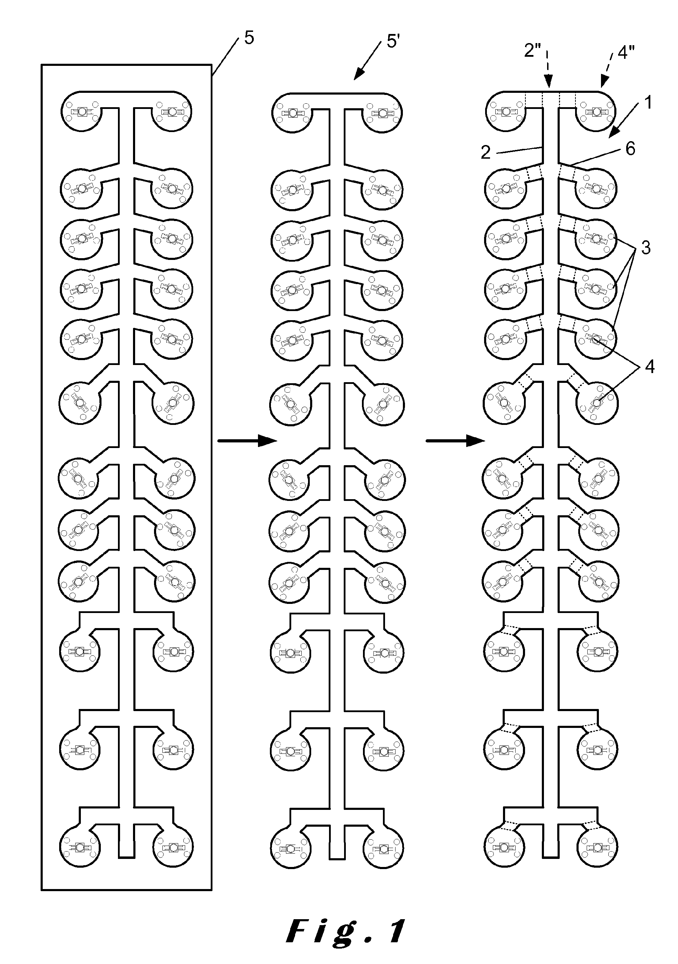

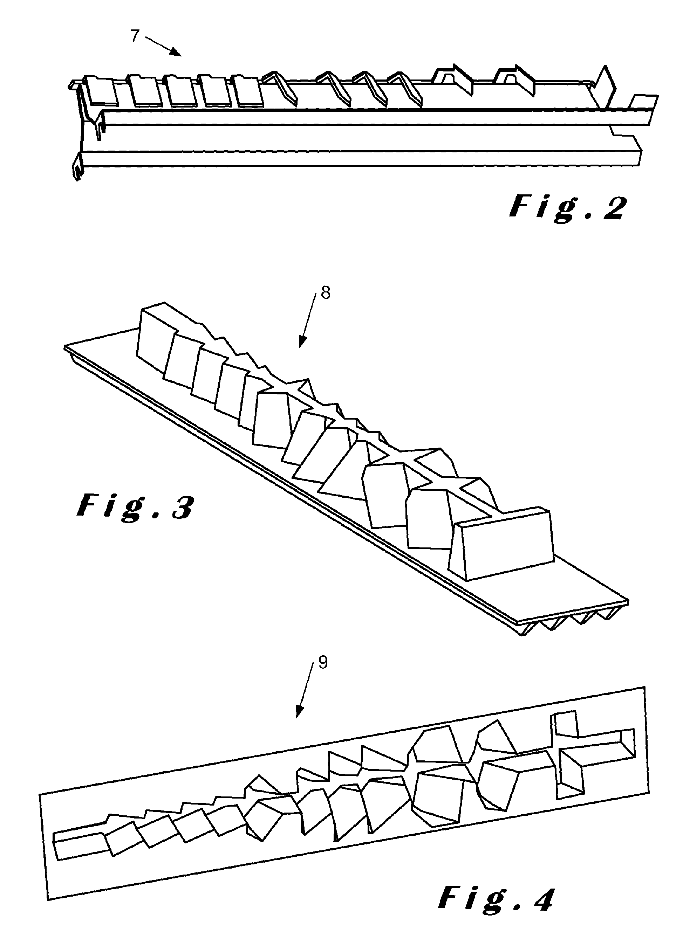

Figures 1 - 4 illustrate three embodiments of the invention using a tree or fishbone shaped PCB structure (designated with reference numeral 1). The tree shaped PCB structure (1) comprises a main stem (2), flexibly bendable side branches (3), and connectors (4) for LED light sources (not represented) including lenses and/or other secondary optics.
The PCB structure (1) constitutes the electronic support on which the LED light sources are provided. The PCB structure (1) is either entirely bendable or comprises rigid parts - stem (2) and connector part (4) - with an intermediate connecting part (6).
Such PCB structures (1) are, for instances, obtained by being cut / punched from a flexibly bendable printed circuitry board material (5), whereas the obtained completely flexible tree structure (5') is provided on the back side with rigid stem portions (2") and "connector support" portions (4''') Figures 2, 3 and 4 show, respectively,
a 3D support structure (7) made of cut and bended metal sheet, with a support structure having a shape substantially corresponding to that of the PCB (1) ;
a 3D support structure (8) made of cast or machined aluminum or molded or machined synthetic material ;
a 3D support structure (9) made of stamped metal or synthetic material ;
the 3D support structures of figures 2, 3 and 4 each comprise a central support part for supporting the stem (2) of a fishbone shaped PCB (1), and a plurality of diversely oriented facets (10) for supporting side branches (3) (with one LED / group of a LED's) of a fishbone shaped PCB (1), thus providing the 3D shape which allows the proper 3D orientation of the LED lights.
Due to the flexible or semi flexible nature of the PCB (1) the support structure (7, 8 or 9) is necessary in order to obtain the mechanical stiffness of the obtained optical system. The PCB (1) is connected (mechanically or by gluing) to the support (7, 8 or 9).
The complete lighting apparatus / light fixture consists of a frame or body (not represented) on / in which are mounted the 3D support structure (7, 8 or 9) with the PCB structure (1), and the LED's and secondary optics.

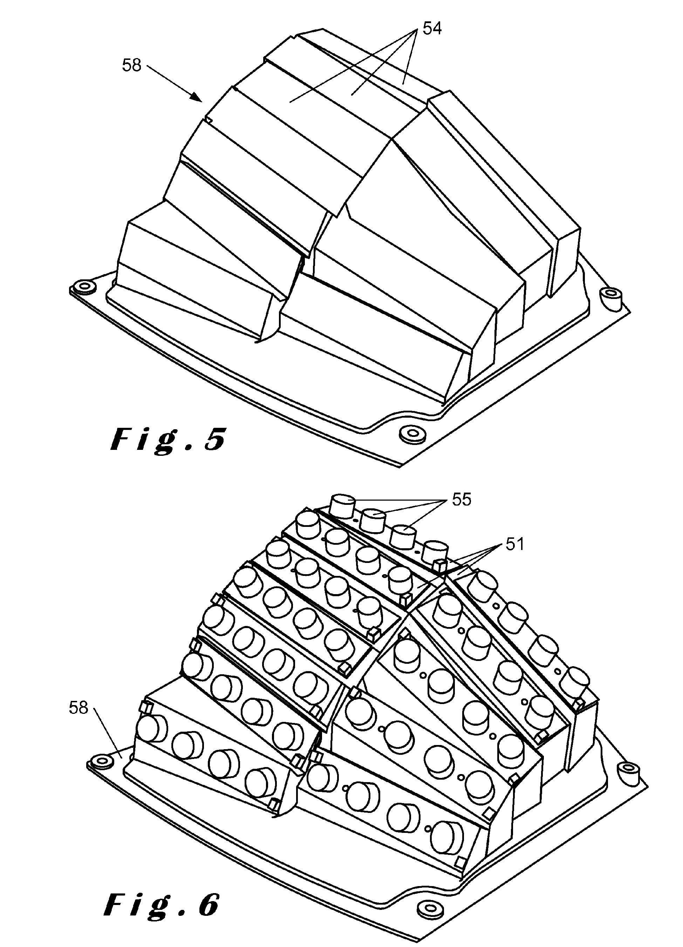

Figures 5 - 6 illustrate an embodiment of the invention using a 3D "heat sink" support structure, designated with reference numeral 58, provided with individual modular PCB structures or PCB modules (51) each bearing four LED's. (55), as shown on fig. 6.
The "heat sink" support structure (58) shows a plurality of photometrically oriented facets (54). The support structure (58) is a foundry or stamped aluminum or synthetic material part.
The PCB modules (51) consist of rigid printed circuitry parts. All modules have common properties (shape, connection features and mechanical features). The modules (51) are attached (mechanically or by gluing) to the support (58).
The geometry of the support is such that each module attached thereto will be oriented in the optimal way. The construction thus provides the desired photometric distribution.
All modules are connected to a centralized power source.

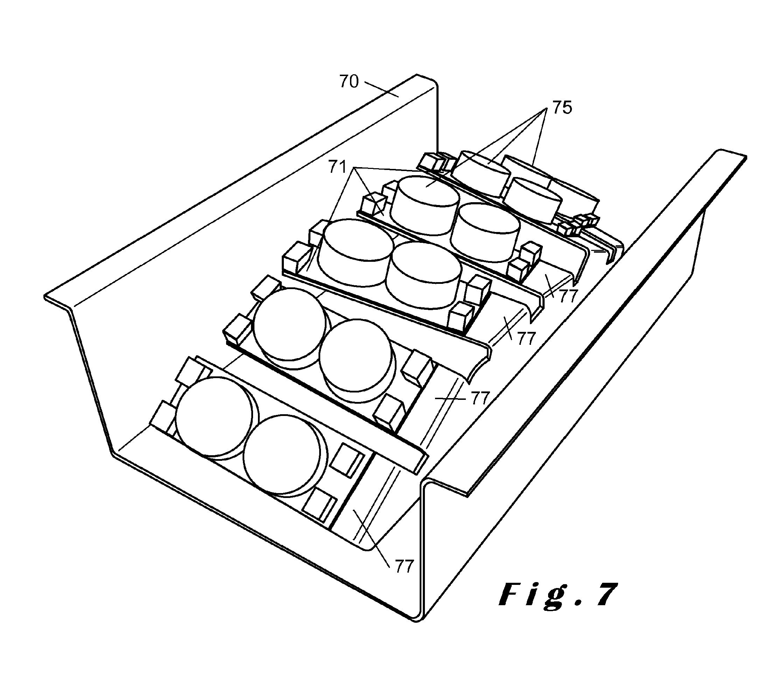

Figure 7 illustrates an embodiment of the invention with thermally conductive support structures (designated with reference numeral 77) provided with modular PCB structures (designated with reference numeral 71), and applied to an external surface of a lighting apparatus (designated with reference numeral 70).
A plurality of individual modular PCB structures (71), each bearing a number of LED's (75) are provided on a plurality of thermally conductive support structures (77).
The modular PCB's (71) may involve several sizes (for two, three, four or five LED's depending on the shape / size of the support structure 77 - in the shown example only with two LED's), but all of a flat and rigid type.
The support structure (77) consists of cut and/or folded metal sheet structures.
Each assembly of a thermally conductive support structure with its modular PCB's (71) and corresponding LED's (75) are mounted to a mounting plate (70) of a lighting apparatus, which mounting plate acts as further heath conveying device.
The PCB's (71) are connected (mechanically or by gluing) to the support structures (77).
The orientation, shape cutting, bending and positioning of all the support structures (77) provide the desired photometric distribution.

The thermal conduction between the LED's (75) will be achieved via the metallic support structures (77) and the external frame of the fixture (plate 70).

## Claims

1. Street lighting apparatus with multiple LED-light sources comprising a three dimensional (3D) support structure and at least one 3D orientated PCB structure for a plurality of LED sources, **characterized in that** said 3D support structure is selected from :
- a cut and/or folded metal sheet structure,
- a cast, machined or molded metal or synthetic material structure,
- a stamped metal or synthetic material structure,
**in that** said 3D orientated PCB structure is selected from :
- a flexible or semi flexible PCB structure for a plurality of LED-light sources, having a shape and/or a three dimensional orientation corresponding to said 3D support structure,
- a plurality of modular PCB structure for a plurality of LED-light sources, each comprising a plurality of LED sources, individually provided to said support structure
**and in that** at least one of the 3D support structure and the PCB structure has heat sink properties.

2. Street lighting apparatus according to claim 1, **characterized in that** said flexible / semi flexible PCB structure comprises a tree or fishbone / herringbone shaped PCB structure, with a main stem and side branches for supporting one LED or a set of LED's, provided on a three dimensional support structure of cut and folded metal, of cast, machined or molded metal or synthetic material, or of stamped metal or synthetic material.

3. Street lighting apparatus according to claim 2, **characterized in that** each side branch of said flexible / semi flexible PCB structure supports a single LED.

4. Street lighting apparatus according to claim 1, **characterized in that** said 3D support structure forms a 3D heat sink support structure, **and in that** a plurality of modular PCB structures, each comprising a plurality of LED sources, are individually provided to said support structure, to provide a structure having photometric oriented facets.

5. Street lighting apparatus according to claim 1, **characterized in that** a plurality of individual modular PCB structures are provided on thermally conductive support structures, which are applied to the external surface of a lighting apparatus.

6. Street lighting apparatus according to claim 5, **characterized in that** said thermally conductive support structures consist of cut and/or folded metal sheet structures.

7. Street lighting apparatus according to any one of claims 5 and 6, **characterised in that** it comprises
individual modules, composed of a heat sink structure (to dissipate, on its backside, the heat generated by the LED-light sources), printed circuitry board (rigid, or flexible for allowing multiple LED orientations on one module), LED-light sources with necessary electronic components, and optional protection and/or tightness features,
a support structure, composed of a 3D main structure, providing an appropriate orientation for each module,
a protector structure (global protector or individual protector for each module),
optionally with a suitably designed "chimney" zone behind the 3D main structure to evacuate the heat into the ambient air.

8. Street lighting apparatus according to any one of claims 5 to 7, **characterised in that** the individual modular PCB structures, each comprising a plurality of LED sources have a rigid structure.
